(19) Europäisches Patentamt
European Patent Office
Office européen des brevets

(11) Numéro de publication : **0 068 941**
**B1**

(12) **FASCICULE DE BREVET EUROPÉEN**

(45) Date de publication du fascicule du brevet : **01.10.86**

(51) Int. Cl.⁴ : **G 08 C 19/30**, H 03 M 11/00

(21) Numéro de dépôt : **82401019.3**

(22) Date de dépôt : **04.06.82**

(54) **Dispositif de lecture des quatre états possibles d'un clavier à trois touches.**

(30) Priorité : **23.06.81 FR 8112338**

(43) Date de publication de la demande : **05.01.83 Bulletin 83/01**

(45) Mention de la délivrance du brevet : **01.10.86 Bulletin 86/40**

(84) Etats contractants désignés : **BE DE GB IT NL SE**

(56) Documents cités :
**DE-A- 1 574 556**
**FR-A- 997 298**
**ELECTRONIC ENGINEERING, vol.50, no.609, juillet 1978, Londres (GB) J.A. CONCANNON: "Cheap multiple functions via Post Office lines", pages 33, 35**

(73) Titulaire : **Bendix Electronics S.A.**
**Avenue du Mirail, B.P. 1149**
**F-31036 Toulouse Cedex (FR)**

(72) Inventeur : **Castel, Michel**
**63, route de Saint Caprais Saint Jory**
**F-31150 Fenouillet (FR)**

(74) Mandataire : **Poidatz, Emmanuel et al**
**Service Brevets Bendix 44 rue François 1er**
**F-75008 Paris (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue St-Denis, 75001 Paris, France

EP 0 068 941 B1

**Description**

L'invention se rapporte aux claviers à touches d'actionnement de contacts électriques destinés à permettre des commandes diverses selon l'état des touches choisies par l'opérateur.

Elle a pour but, dans le cas d'un clavier à quatre états possibles, de fournir un dispositif dont le circuit électrique pour la lecture des quatre états possibles du clavier soit particulièrement simple.

A cet effet, l'invention concerne un dispositif pour la lecture des quatre états possibles d'un clavier muni de trois touches à action non simultanée agissant chacune sur un contact électrique, caractérisé en ce que le clavier se présente sous la forme d'un dipôle entre les bornes duquel sont disposées en parallèle trois liaisons comprenant chacune l'un desdits contacts électriques, deux de ces liaisons incluant chacune une diode, les deux diodes étant montées tête-bêche et en série avec le contact électrique correspondant, ledit dispositif comprenant également des moyens pour appliquer successivement deux tensions électriques inverses aux bornes du dipôle, des moyens pour détecter les états logiques correspondants engendrés aux bornes respectives du dipôle par l'application des tensions électriques inverses et des moyens de discrimination pour déduire l'état du clavier desdits états logiques.

Suivant un mode de réalisation de l'invention, les moyens pour détecter lesdits états logiques correspondants comprennent des résistances connectées en parallèle à la masse par rapport aux moyens d'application desdites tensions électriques.

Suivant un autre mode de réalisation, les moyens d'application de deux tensions électriques inverses, de détection des états logiques correspondants et de discrimination pour déduire l'état du clavier comprennent un microprocesseur ayant deux sorties coopérant avec des moyens générant lesdites tensions inverses et deux entrées respectivement connectées aux bornes du clavier dipôle.

Un tel dispositif, outre son simple câblage de connexion à deux fils, présente l'avantage de n'utiliser que des composants passifs dans le clavier et se prête à une lecture logique à composants simples (tels que transistors d'application sélective de tension et résistances de détection des états logiques) tout en tolérant par son principe de lecture des résistances parasites internes au clavier qui peuvent être relativement importantes.

L'invention est décrite plus en détail ci-après à l'aide d'exemples représentés au dessin annexé, dans lequel :

la figure 1 est un schéma électrique de principe d'un clavier et de ses moyens de lecture ;

la figure 2 est un schéma électrique de principe d'un dispositif de lecture du clavier de la figure 1 faisant appel à un microprocesseur ;

la figure 3 est un tableau illustratif des divers états logiques correspondant aux quatre états possibles du clavier dans le cas de la fig. 2.

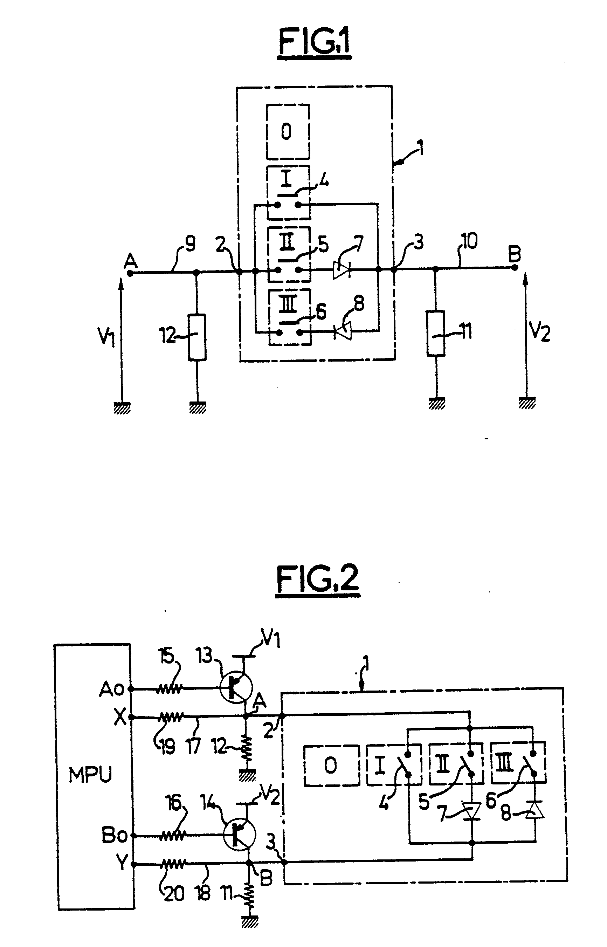

Le clavier schématisé à la fig. 1 est désigné par 1 dans son ensemble est un clavier dipôle à deux bornes 2 et 3, entre lesquelles sont ménagées trois liaisons en parallèle comprenant chacune un contact électrique sélectivement actionnable à la fermeture ou à l'ouverture par une touche du clavier, soit respectivement les contacts 4, 5, 6 actionnables par les touches schématisées et désignées par I, II, III.

Sur deux de ces liaisons internes, il est en outre prévu deux diodes 7, 8 montées tête-bêche.

Il est à voir qu'un tel clavier peut ainsi présenter quatre états distincts :

état 0 : aucun contact fermé ;

état I : touche I enfoncée, contact correspondant 4 fermé ;

état II : touche II enfoncée, contact correspondant 5 fermé ;

état III : touche III enfoncée, contact correspondant 6 fermé.

L'agencement des touches peut être tel, de manière bien connue et en dehors de l'invention, qu'une seule touche puisse être enfoncée à la fois et provoque le rappel de tout autre touche préalablement enfoncée, la touche enfoncée pouvant être libérée par une action d'enfoncement subsidiaire. L'agencement du clavier peut aussi comporter comme schématisé quatre touches à enfoncement unique au choix, dont une ici marquée 0 ne servant qu'à rappeler toute autre touche I, II, III préalablement enfoncée.

La lecture des états du clavier consiste à appliquer successivement et séparément deux tensions électriques inverses aux bornes 2 et 3 de celui-ci, respectivement générées par les tensions V1 et V2 appliquées en A et B à des conducteurs 9, 10 reliés aux bornes 2 et 3, les états de courant passant étant mis en évidence ou détectés à l'aide de résistances 11, 12 branchées en parallèle à la masse par rapport aux sources d'application de tension positive V1 et V2.

Si l'on appelle V*1, V*2 la tension lue à l'une des bornes du clavier, ici en A ou B, lorsque l'autre est mise sous tension positive, on obtient ainsi quatre couples d'états logiques distincts représentatifs de l'état du clavier, soit :

(V*2, V*1) = (0,0) Etat 0 (aucun courant passant)

(V*2, V*1) = (1,1) Etat I (courant passant bidirectionnel)

(V*2, V*1) = (1,0) Etat II (courant unidirectionnel de A vers B)

(V*2, V*1) = (0,1) Etat III (courant unidirectionnel de B vers A)

Un exemple de mode de lecture du clavier par un dispositif logique faisant appel à un microprocesseur MPU est représenté à la fig. 2, dans laquelle on a conservé les mêmes chiffres de référence qu'à la fig. 1 pour les parties équivalentes.

Des moyens d'application sélective de tension aux bornes du clavier sont constitués par des transistors 13, 14, dont les bases sont reliées par l'intermédiaire de résistances de polarisation 15, 16 à des sorties correspondantes Ao, Bo du microprocesseur.

La lecture sélective des tensions aux points A, B est assurée par l'intermédiaire de conducteurs 17, 18 reliant ces points, par interposition de résistances de limitation de courant 19, 20, à des entrées de lecture X et Y du microprocesseur.

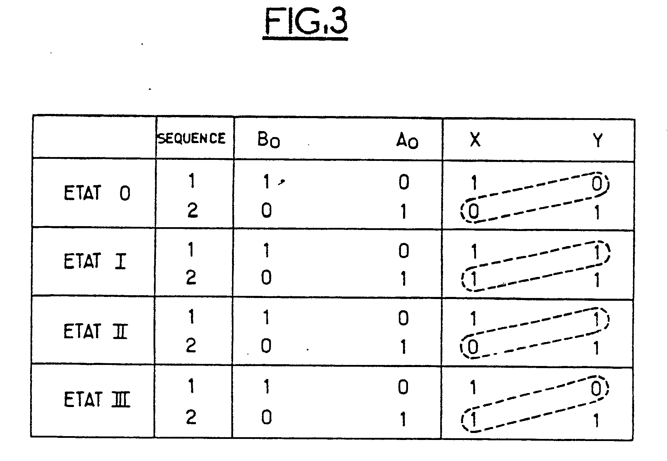

La fig. 3 donne le tableau des différents états logiques, selon les quatre états 0, I, II, III du clavier, et selon les deux phases de la séquence de lecture de chaque état possible du clavier. On notera que les états du clavier peuvent être discriminés en X et Y par un programme d'application sélective de tension et de lecture conduisant à une activation simultanée et alternée des couples sortie-entrée AoY et BoX du microprocesseur, ce qui revient à lire pour chaque état les couples logiques qui sont encerclés en pointillé dans les cases d'états X, Y et correspondent à ceux déjà indiqués à l'occasion de la fig. 2.

## Revendications

1. Dispositif pour la lecture des quatre états possibles (0, I, II, III) d'un clavier muni de trois touches à action non simultanée agissant chacune sur un contact électrique (4, 5, 6), caractérisé en ce que le clavier se présente sous la forme d'un dipôle entre les bornes (2, 3) duquel sont disposées en parallèle trois liaisons comprenant chacune l'un desdits contacts électriques (4, 5, 6), deux de ces liaisons incluant chacune une diode (7, 8), les deux diodes étant montées tête-bêche et en série avec le contact électrique correspondant, ledit dispositif comprenant également des moyens (MPU, 13-16) pour appliquer successivement deux tensions électriques inverses (V1, V2) aux bornes du dipôle, des moyens (MPU, 11, 12) pour détecter les états logiques correspondants (X, Y) engendrés aux bornes respectives (2, 3) du dipôle par l'application des tensions électriques inverses (VI, V2) et des moyens de discrimination (MPU) pour déduire l'état du clavier desdits états logiques (X, Y).

2. Dispositif selon la revendication 1, caractérisé en ce que les moyens pour détecter lesdits états logiques correspondants comprennent des résistances (11, 12) connectées en parallèle à la masse par rapport aux moyens (13-16) d'application desdites tensions électriques inverses.

3. Dispositif selon l'une quelconque des revendications 1 et 2, caractérisé en ce que les moyens d'application de deux tensions électriques inverses, de détection des états logiques correspondants et de discrimination pour déduire l'état du clavier comprennent un microprocesseur (MPU) ayant deux sorties (AO, BO) coopérant avec des moyens (13-16) générant lesdites tensions inverses et deux entrées respectivement connectées aux bornes (2, 3) du clavier dipôle.

## Claims

1. Apparatus for reading the four possible states (0, I, II, III) of a keyboard provided with three keys of non-simultaneous action type each of which acts on an electrical switch (4, 5, 6) characterised in that the keyboard is in the form of a dipole between the terminals (2, 3) of which are disposed in parallel three connections each comprising one of said electrical switches (4, 5, 6), two of said connections each including a diode (7, 8), the two diodes being in opposite parallel relationship and in series with the corresponding electrical switch, said apparatus also comprising means (MPU, 13-16) for successively applying two inverse electrical voltages (V1, V2) to the terminals of the dipole, means (MPU, 11, 12) for detecting the corresponding logic states (X, Y) produced at the respective terminals (2, 3) of the dipole by the application of the inverse electrical voltages (V1, V2) and discriminator means (MPU) for deducing the state of the keyboard from said logic states (X, Y).

2. Apparatus according to claim 1 characterised in that the means for detecting said corresponding logic states comprise resistors (11, 12) connected in parallel to earth with respect to the means (13-16) for applying said inverse electrical voltages.

3. Apparatus according to either one of claims 1 and 2 characterised in that the means for applying two inverse electrical voltages, the means for detecting the corresponding logic states and the discriminator means for deducing the state of the keyboard comprise a microprocessor (MPU) having two outputs (AO, BO) cooperating with means (13-16) for generating said inverse voltages and two inputs respectively connected to the terminals (2, 3) of the dipole keyboard.

## Patentansprüche

1. Einrichtung zur Ermittlung der vier möglichen Zustände (0, I, II, III) einer mit drei Tasten versehen Tastatur mit nicht simultaner Wirkung, deren jede auf einen elektrischen Kontakt (4, 5, 6) wirkt, dadurch gekennzeichnet, daß die Tastatur die Form eines Dipols aufweist, zwischen dessen Anschlüssen (2, 3) drei Verbindungen parallel angeordnet sind, deren jede einen der genannten elektrischen Kontakte (4, 5, 6) aufweist, wobei zwei dieser Verbindungen jeweils eine Diode (7, 8) aufweisen und die beiden Dioden verkehrt zueinander angeordnet sind sowie in Serie mit dem zugehörigen elektrischen Kontakt, daß die Einrichtung außerdem Mittel (MPU, 13-16) aufweist um nacheinander zwei inverse elektrische Spannungen (V1, V2) an die Anschlüsse des Dipols anzulegen, eine Anordnung (MPU, 11, 12) aufweist, zur Erfassung der zugehörigen logischen Zustände (X, Y), die an den entsprechenden Anschlüssen (2, 3) des Dipols durch Anlegen der inversen elektrischen Spannungen (V1, V2) erzeugt werden und eine Unterscheidungsanordnung (MPU) aufweist, um den Zustand der Tastatur aus den logischen Zuständen (X, Y) abzuleiten.

2. Einrichtung nach Anspruch 1, dadurch gekennzeichnet, daß die Anordnung zur Erfassung der zugehörigen logischen Zustände Widerstände (11, 12) aufweist, die parallel mit der Masse verbunden sind bezüglich der Anordnung (13-16) zur Anlegung der inversen elektrischen Spannungen.

3. Einrichtung nach einem der Ansprüche 1 und 2, dadurch gekennzeichnet, daß die Anordnung zur Anlegung der beiden inversen elektrischen Spannungen zur Erfassung der zugehörigen logischen Zustände und zur Unterscheidung um den Zustand der Tastatur abzuleiten, einen Mikroprozessor (MPU) aufweist mit zwei Ausgängen (AO, BO), der mit der Anordnung (13-16) zusammenwirkt, welche die inversen Spannungen erzeugt und zwei Eingänge aufweist, die mit den entsprechenden Anschlüssen (2, 3) der Dipol-Tastatur verbunden sind.

FIG.1

0
I
II
III
1
4
5
6
7
8
9
10
2
3
A
B
V1
V2
12
11

FIG.2

MPU
Ao
X
Bo
Y
V1
V2
A
B
15
13
19
17
12
16
14
20
18
11
1
2
3
0
I
II
III
4
5
6
7
8

FIG.3

| | SEQUENCE | Bo | Ao | X | Y |
|---|---|---|---|---|---|
| ETAT 0 | 1 | 1 | 0 | 1 | 0 |
| | 2 | 0 | 1 | 0 | 1 |
| ETAT I | 1 | 1 | 0 | 1 | 1 |
| | 2 | 0 | 1 | 1 | 1 |
| ETAT II | 1 | 1 | 0 | 1 | 1 |
| | 2 | 0 | 1 | 0 | 1 |
| ETAT III | 1 | 1 | 0 | 1 | 0 |
| | 2 | 0 | 1 | 1 | 1 |